(19) Europäisches Patentamt

European Patent Office

Office européen des brevets

(11) **EP 1 017 162 A2**

(12) **EUROPEAN PATENT APPLICATION**

(43) Date of publication:
05.07.2000 Bulletin 2000/27

(51) Int. Cl.[7]: **H03F 1/32**

(21) Application number: **99204583.1**

(22) Date of filing: **24.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **30.12.1998 US 114279 P**

(71) Applicant:
**Texas Instruments Incorporated
Dallas, Texas 75251 (US)**

(72) Inventors:
• **Gharpurey, Ranjit
Garland, Texas 75244 (US)**
• **Bellaouar, Abdellatif
Dallas, Texas 75243 (US)**
• **Khatibzadeh, Mohammad
Plano, Texas 75024 (US)**

(74) Representative: **Holt, Michael
Texas Instruments Limited,
European Patents Department (MS 13),
PO Box 5069
Northampton NN4 7ZE (GB)**

(54) **Amplifier circuit with negative feedback loop for distortion reduction**

(57) A circuit is designed with a first amplifier circuit (406) having a first input terminal (422), a second input terminal (404) and a first output terminal (408). The second input terminal is coupled to receive a phase-modulated signal. A second amplifier circuit (420) has a third input terminal (416), a fourth input terminal (418) and a second output terminal (422). The fourth input terminal is coupled to receive an amplitude signal. A sample circuit (410, 414) is coupled between the first output terminal and the third input terminal.

FIG. 4

## Description

FIELD OF THE INVENTION

This invention relates to RF power transmission for a communication system and more particularly to a new transmitter architecture for amplitude and phase modulation.

BACKGROUND OF THE INVENTION

Previous generation modulation schemes, such as Gaussian Mean Shift Keying (GMSK) were popular because of their constant amplitude modulation envelope. This constant amplitude modulation envelope permitted non-linear, yet power-efficient operation of an RF power amplifier. Present modulation schemes in wireless applications, such as quadrature amplitude modulation (QAM), however, require transmitters that can transmit amplitude and phase modulated signals to maximize symbol transmission efficiency. Power amplifiers for these amplitude and phase modulation schemes require linear operation to preserve narrow-band properties of the modulation. Linear operation of a class A power amplifier, for example, preserves the narrow-band modulation properties. Quiescent power dissipation of the class A amplifier, however, is highly disadvantageous. Alternative power amplifier designs, such as class AB, B and C amplifiers, are more power-efficient, but non-linear operation precludes their use for amplitude and phase modulation schemes.

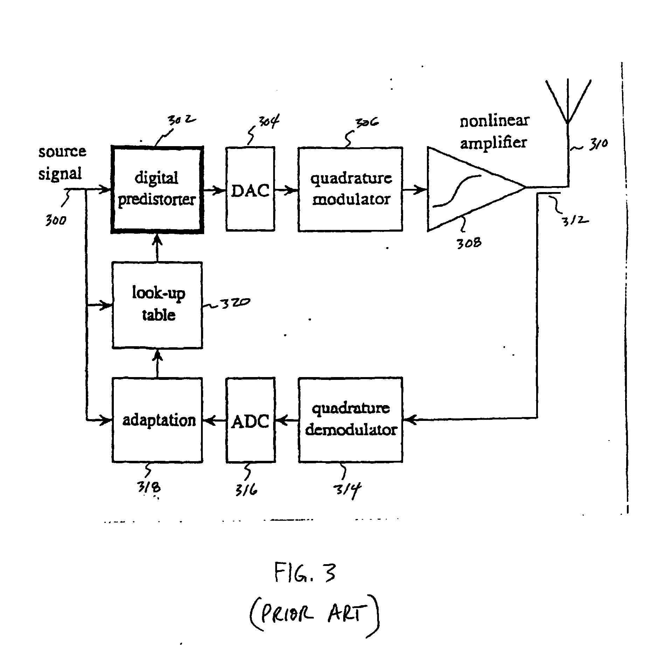

This problem was previously discussed by L. Sundstrom et al., *Quantitization Analysis and Design of a Digital Predistortion Linearizer for RF Power Amplifiers,* IEEE Trans. on Veh. Tech., vol. 45, no. 4, 707 (Nov. 1996) as in FIG. 3. Therein, Sundstrom et al. taught use of a digital signal processor (DSP) 302 to predistort a base-band source signal 300 using a look-up table 320. This predistorted base-band signal was then applied to a digital-to-analog converter (DAC) 304 and to a quadrature modulator circuit 306. The resulting predistorted phase modulated signal was then applied to a non-linear power amplifier circuit 308. Sundstrom et al. further taught that an improved application-specific DSP greatly improved efficiency of the predistortion scheme. The improved predistortion scheme, however, still required constant updates of the look-up table 320. This updating was accomplished by a quadrature demodulator 314 that received an RF sample 312 and compared it with the signal source on lead 300. Moreover, the application-specific DSP increased cost and circuit complexity of the design.

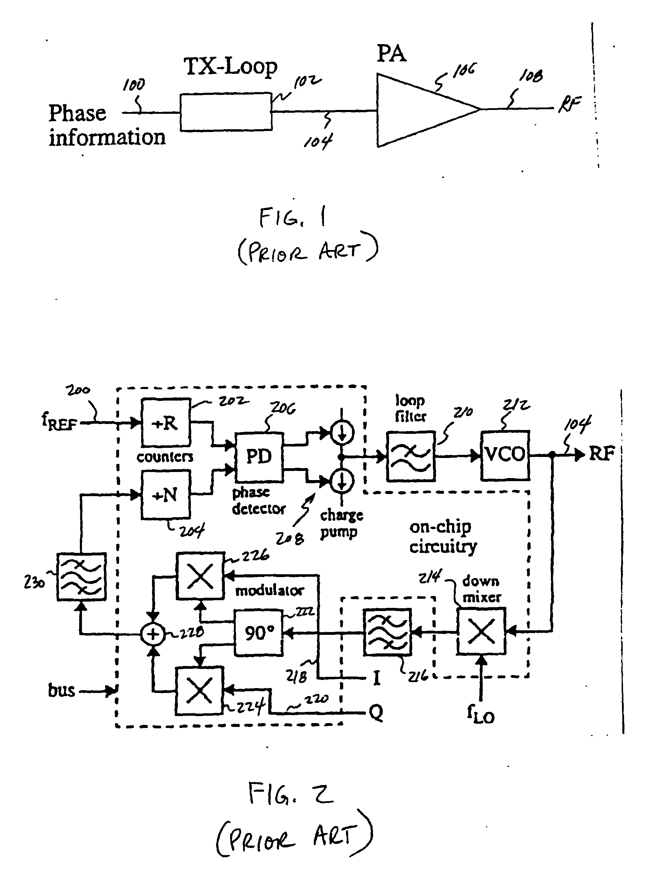

A further improvement in RF power transmission was taught by G. Irvine et al., *An Up-Conversion Loop Transmitter IC for Digital Mobile Telephones,* IEEE Proc. of the ISSCC, no. SP 23.1, 364 (1998). Irvine et al. taught an up-conversion loop transmitter or transmit loop 102 (FIG. 1) that modulated a phase signal on lead 100 and produced a phase modulated output signal on lead 104. This transmit loop circuit functioned as a phase-locked loop to drive the power amplifier circuit 106 directly, thereby lowering the noise floor and eliminating an expensive duplex filter and driver stage.

The transmit loop circuit (FIG. 2) of the prior art produces an RF frequency determined by a ratio of divide-by R 202 and divide-by N 204 counters. The divide-by R counter divides a reference frequency on lead 200. The divide-by N counter divides a sample frequency that is down-converted by mixer circuit 214. Phase shift at the phase detector circuit 206 input due to the I and Q modulator is canceled by feeding back a VCO 212 sample that is equal and opposite in phase. Phase detector circuit 206 compares the divided frequencies and produces a correction signal that is loop filtered and applied to VCO 212. Irvine et al. teach that this circuit advantageously produces lower amplitude modulation than other techniques, so the power amplifier can operate closer to compression. A major disadvantage of this circuit, however, is that direct connection can only provide phase modulation. The RF output of the transmit loop circuit has a constant amplitude.

SUMMARY OF THE INVENTION

The foregoing problems are resolved by a circuit with a first amplifier circuit having a first input terminal, a second input terminal and a first output terminal. The second input terminal is coupled for receiving a phase-modulated signal. A second amplifier circuit has a third input terminal, a fourth input terminal and a second output terminal. The fourth input terminal is coupled for receiving an amplitude signal. A sample circuit is coupled between the first output terminal and the third input terminal.

The disclosed circuit provides power amplifier amplitude and phase modulation. Non-linear power amplifier operation is possible without compromise to narrow-band properties of the modulation.

BRIEF DESCRIPTION OF THE DRAWINGS

A more complete understanding of the invention may be gained by reading the subsequent detailed description with reference to the exemplary embodiments illustrated in the accompanying drawings wherein:

    FIG. 1 is a simplified block diagram of a transmit loop circuit and a power amplifier circuit of the prior art;
    FIG. 2 is a block diagram of the transmit loop circuit of FIG. 1 of the prior art;
    FIG. 3 is a block diagram of a digital predistortion linearizer of the prior art for an RF power amplifier;
    FIG. 4 is a block diagram of an embodiment of an amplitude and phase modulated power amplifier;

FIG. 5 is a block diagram of another embodiment of an amplitude and phase modulated power;

FIG. 6 is a block diagram of yet another embodiment of an amplitude and phase modulated power; and

FIG. 7 is a block diagram of a fourth embodiment of an amplitude and phase modulated power amplifier.

## DETAILED DESCRIPTION OF THE PREFERRED EMBODIMENTS

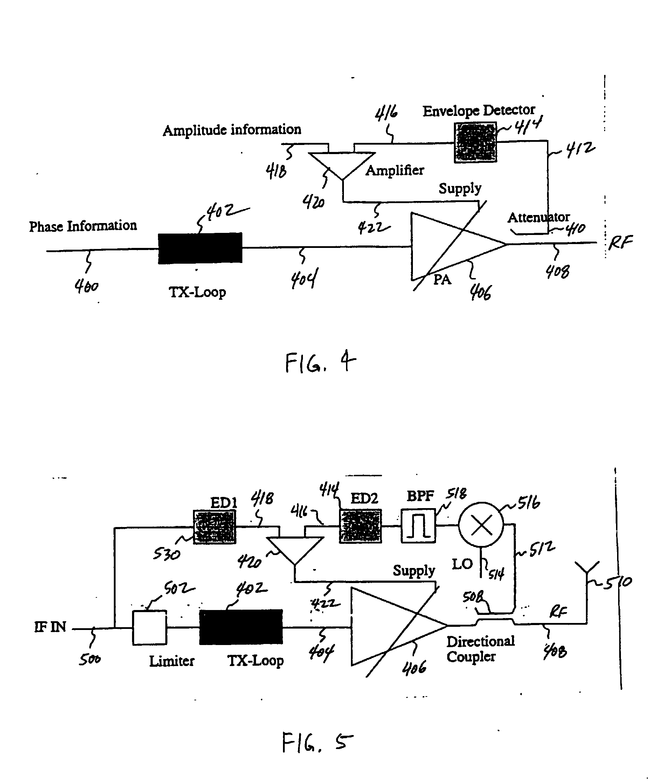

Referring now to FIG. 4, there is a block diagram of an embodiment of an amplitude and phase modulated power amplifier circuit. The circuit includes a transmit loop circuit 402 coupled to power amplifier circuit 406. A sample circuit including attenuator 410 and envelope detector circuit 414 is coupled between power amplifier circuit output terminal 408 and input terminal 416 of amplifier circuit 420. Amplifier circuit 420 is preferably a high gain operational amplifier. Input terminal 418 of amplifier circuit 420 is coupled to receive an amplitude information signal. An output terminal 422 of amplifier circuit 420 is coupled to the power amplifier circuit power supply input terminal.

In operation, the circuit receives a phase signal on lead 400. Transmit loop circuit 402 phase modulates this phase information signal and produces a phase modulated RF output signal on lead 404. Power amplifier circuit 406 receives the phase modulated RF output signal and produces an RF output signal on lead 408. Attenuator 410 produces an attenuated sample of this RF output signal on lead 412. An envelope detector circuit 414 detects the envelope amplitude and produces a corresponding amplitude sample signal on lead 416. Amplifier circuit 420 receives this amplitude sample signal on lead 416 for comparison with an amplitude information signal on lead 418 and produces an output signal at the power supply input terminal of power amplifier circuit 406. This arrangement is highly advantageous in providing amplitude and phase modulation of the RF output signal at lead 408. The sample circuit formed by attenuator 410 and envelope detector 414 together with amplifier circuit 420 forms a negative feedback loop for regulating power of amplifier circuit 406. Thus, the RF output signal at lead 408 tracks the low-frequency amplitude input signal on lead 418. This negative feedback loop, therefore, is a low-frequency tracking loop that greatly reduces distortion the power amplifier. The RF output signal on lead 408 is linearized at a lower cost and circuit complexity than solutions of the prior art.

Turning now to FIG. 5, there is a block diagram of another embodiment of an amplitude and phase modulated power amplifier of. This circuit includes a limiter circuit coupled to receive an intermediate frequency (IF) signal at lead 500 that is amplitude and phase modulated. The transmit loop circuit 402 is coupled between the limiter circuit 502 and the power amplifier circuit 406. A sample circuit, including directional coupler circuit 508, down-converter 516, bandpass filter 518 and envelope detector circuit 414, is coupled between power amplifier circuit output terminal 408 and input terminal 416 of amplifier circuit 420. Envelope detector circuit 530 is coupled between lead 500 and input terminal 418 of amplifier circuit 420. An output terminal 422 of amplifier circuit 420 is coupled to the power amplifier circuit power supply input terminal.

In operation, the limiter circuit 502 converts the IF signal on lead 500 to a constant amplitude, phase modulated signal, thereby removing the amplitude component from the IF signal. Transmit loop circuit 402 phase modulates this IF signal to an RF frequency on lead 404. Power amplifier circuit 406 receives the phase modulated RF signal and produces an RF output signal on lead 408. Directional coupler 508 provides tight coupling between the power amplifier output and lead 408 as well as an attenuated sample of the RF output signal on lead 512. This directional coupler is advantageous in suppressing in-band signals from antenna 510. Mixer circuit 516 down converts the RF sample on lead 512 to the IF signal frequency with local oscillator signal LO on lead 514. This IF signal frequency is applied to bandpass filter circuit 518. An envelope detector circuit 414 detects the envelope amplitude from the bandpass filter circuit 518 and produces a corresponding amplitude sample signal on lead 416. Amplifier circuit 420 receives this amplitude sample signal on lead 416 for comparison with an IF amplitude signal on lead 418 from envelope detector circuit 530. Amplifier circuit 420 produces an output signal at the power supply input terminal 422 of power amplifier circuit 406. This arrangement provides the same advantages as in the embodiment of FIG. 4 for an IF input signal on lead 500. The negative feedback loop regulates the power of amplifier circuit 406 and greatly reduces distortion.

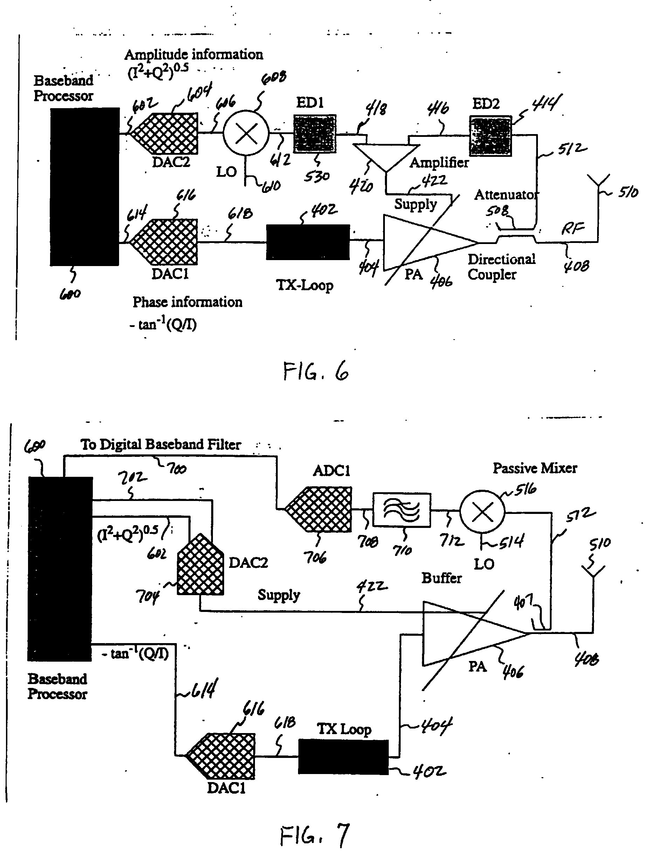

Referring to FIG. 6, there is a block diagram of yet another embodiment of an amplitude and phase modulated power amplifier. This embodiment differs from previous embodiments by generating amplitude and phase information directly from a baseband processor circuit 600. The signal path, therefore, avoids an IF modulator section. This circuit includes a digital-to-analog converter 616 coupled to receive digital phase information on lead 614 from the baseband processor. The transmit loop circuit 402 is coupled between the digital-to-analog converter circuit 616 and the power amplifier circuit 406. A sample circuit, including directional coupler circuit 508 and envelope detector circuit 414, is coupled between power amplifier circuit output terminal 408 and input terminal 416 of amplifier circuit 420. Another digital-to-analog converter 604 is coupled to receive digital amplitude information on lead 602 from the baseband processor. An up-converter circuit 608 couples the digital-to-analog converter circuit 604 to another envelope detector circuit 530. Envelope detector circuit 530 is coupled to input terminal 418 of amplifier circuit 420. An output terminal 422 of amplifier circuit 420 is coupled to the power amplifier circuit power supply input terminal.

In operation, the baseband processor circuit 600 produces digital amplitude and phase information an leads 602 and 614, respectively. This amplitude and phase information given in equations [1] and [2], respectively, is derived from I and Q channels corresponding to real and imaginary components of a data symbol.

$$Amplitude = \sqrt{I^2 + Q^2} \qquad [1]$$

$$Phase = -tan^{-1}(Q/I) \qquad [2]$$

Digital-to-analog converter 616 converts the digital version of the phase information on lead 614 to an analog version of the phase information on lead 618. Transmit loop circuit 402 phase modulates this analog phase signal to an RF frequency on lead 404. Power amplifier circuit 406 receives the phase modulated RF signal and produces an RF output signal on lead 408. Directional coupler 508 provides tight coupling between the power amplifier output and lead 408 as well as an attenuated sample of the RF output signal on lead 512. An envelope detector circuit 414 detects the envelope amplitude from the RF sample signal on lead 512 and produces a corresponding amplitude sample signal on lead 416. Digital-to-analog converter circuit 604 receives the digital version of the amplitude signal on lead 602 and produces an analog version of the amplitude signal on lead 606. An up converter circuit receives a local oscillator signal LO on lead 610 and converts the analog amplitude signal to an RF frequency on lead 612. This local oscillator signal LO is advantageously a fixed frequency and amplitude signal derived from the transmit loop circuit 402. Thus, an RF frequency at lead 612 tracks the RF frequency at lead 404. Envelope detector circuit 530 receives the RF amplitude signal on lead 612 and produces a corresponding amplitude signal on lead 418. Amplifier circuit 420 receives respective amplitude signals on leads 416 and 418 and produces an output signal at the power supply input terminal 422 of power amplifier circuit 406. This arrangement provides the same advantages as previous embodiments. Amplitude and phase information, however, are taken directly from the baseband processor circuit, thereby avoiding an IF modulator signal path. The up converter circuit 608 is included, rather than using amplitude information at lead 606 directly, so that non-linearity of envelope detector circuit 530 will match the non-linearity of envelope detector circuit 414.

Turning now to FIG. 7, there is a block diagram of a fourth embodiment of an amplitude and phase modulated power amplifier. This embodiment generates amplitude and phase information directly from a baseband processor circuit 600 as described in the embodiment of FIG. 6. The signal path, therefore, avoids an IF modulator section. The phase signal path is also the same as described in the embodiment of FIG. 6. A sample circuit, including attenuator 407, mixer circuit 516, anti-aliasing filter 710 and analog-to-digital converter 706, is coupled between power amplifier circuit output terminal 408 and baseband processor circuit 600 input terminal 700. Digital-to-analog converter 704 is coupled to receive digital amplitude information from the sample circuit on lead 702 and generated amplitude information on lead 602. An output lead 422 of digital-to-analog converter circuit 704 is coupled to the power amplifier circuit power supply input terminal.

Operation of the phase information signal path is the same as previously described for the embodiment of FIG. 6. Attenuator 407 produces an attenuated RF sample signal on lead 512. Mixer circuit 516 receives this RF sample and a local oscillator signal LO on lead 514 having the RF transmit frequency. Mixer circuit 516 produces a beat frequency on lead 712 that is separated from high frequency components by anti-aliasing filter 710 and applied to analog-to-digital converter circuit 706. Analog-to-digital converter circuit 706 applies a digital version of this feedback sample signal to baseband processor circuit 600 on lead 700. A digital filter within the baseband processor circuit provides additional filtering and produces this feedback sample signal on lead 702. Together with anti-aliasing filter 710, the digital filter removes any spurious out-of-band signals that may have been picked up by antenna 510. The baseband processor circuit 600 generates digital amplitude information as in equation [1] on lead 602. Digital-to-analog converter circuit 704 compares the digital amplitude feedback signal on lead 702 with the generated amplitude information signal on lead 602 and produces an output signal at the power supply input terminal 422 of power amplifier circuit 406. This arrangement provides the same advantages as previous embodiments. Amplitude and phase information are taken directly from the baseband processor circuit, thereby avoiding an IF modulator signal path. The mixer circuit 516, however, down converts the RF sample signal on lead 512 rather than up converting the baseband amplitude signal as in the embodiment of FIG. 6.

The transmitter architecture of the previously described embodiments provides several notable advantages over circuits of the prior art. First, the power amplifier may be used in compression or non-linear mode, while retaining linear performance. Thus, quiescent power of the power amplifier is greatly reduced. Second, the transmit loop circuit has a very low noise floor due to high power consumption in the VCO. Thus, a bandpass filter before the power amplifier to suppress noise in the receive band is unnecessary. Third, the architecture may be fabricated on a single integrated circuit. Fourth, interference in CDMA systems due to other transmitters may be minimized by the baseband processor, since the modulation code for the base station is known.

Although the circuit has been described in detail with reference to its preferred embodiment, it is to be understood that this description is by way of example only and is not to be construed in a limiting sense. For example, the power supply input terminal at lead 422 may alternatively be an input terminal of a low impedance drive circuit intermediate a power supply source terminal and the power amplifier 406. This low impedance drive circuit, for example, may be an emitter follower or source follower as is well known to those of ordinary skill in the art. Moreover, de-correlation of generated and feedback amplitude signals in the embodiment of FIG. 7 need not be performed at the baseband processor circuit. Such de-correlation may be performed later between the spread signals. The resultant error signal may then be used to drive the power amplifier power supply input terminal.

It is understood that the inventive concept of the present invention may be embodied in a mobile communication system as well as circuits within the mobile communication system. It is to be further understood that numerous changes in the details of the embodiments of the invention will be apparent to persons of ordinary skill in the art having reference to this description. It is contemplated that such changes and additional embodiments are within the spirit and true scope of the invention.

## Claims

1. A circuit, comprising:

   a first amplifier circuit having a first input terminal, a second input terminal and a first output terminal, the second input terminal coupled for receiving a phase modulated signal;
   a second amplifier circuit having a third input terminal, a fourth input terminal and a second output terminal, the fourth input terminal coupled for receiving an amplitude signal; and
   a sample circuit coupled between the first output terminal and the third input terminal.

2. A circuit as claimed in claim 1, wherein the first input terminal comprises a power supply terminal.

3. A circuit as claimed in claim 1 or claim 2, wherein the first amplifier comprises a power amplifier arranged for producing an amplitude and phase modulated signal at the first output terminal.

4. A circuit as claimed in any preceding claim, wherein the second amplifier comprises a coupled for receiving a feedback signal from the first output terminal at the third input terminal and an amplitude signal at the fourth input terminal.

5. A circuit as claimed in any preceding claim, further comprising:

   a transmit loop circuit having a loop input terminal coupled for receiving a phase signal and having a loop output terminal coupled to the second input terminal, the transmit loop circuit arranged for producing the phase modulated signal at the loop output terminal.

6. A circuit as claimed in any preceding claim, wherein the sample circuit comprises a first envelope detector circuit coupled between the first output terminal and the third input terminal.

7. A circuit as claimed in claim 6, wherein the sample circuit further comprising:

   an attenuator coupled between the first output terminal and the first envelope detector circuit, the attenuator arranged for applying an attenuated sample of a signal at the first output terminal to the first envelope detector circuit.

8. A circuit as claimed in claim 6, wherein the sample circuit further comprises:

   a directional coupler circuit having an input terminal coupled to the first output terminal and having a sample terminal coupled to the first envelope detector circuit, the directional coupler circuit arranged for producing at the sample terminal an attenuated sample of a signal at the first output terminal.

9. A circuit as claimed in claim 8, wherein the sample circuit further comprises:

   a converter circuit coupled to the sample terminal; and
   a filter circuit coupled between the converter circuit and the first envelope detector circuit.

10. A circuit as claimed in claim 8, further comprising:

   a processor circuit arranged for producing the amplitude signal and a phase signal; and
   a transmit loop circuit having a loop input terminal coupled for receiving the phase signal and having a loop output terminal coupled to the second input terminal, the transmit loop circuit arranged for producing the phase modulated signal at the loop output terminal.

11. A circuit as claimed in claim 10, further comprising:

   a first digital-to-analog converter circuit coupled between the processor circuit and the fourth input terminal, first digital-to-analog converter circuit coupled for receiving a digital version of the amplitude signal from the processor circuit, the first digital-to-analog converter circuit arranged for producing an analog version of the amplitude signal; and

a second digital-to-analog converter circuit coupled between the processor circuit and the loop input terminal, second digital-to-analog converter circuit coupled for receiving a digital version of the phase signal from the processor circuit, the second digital-to-analog converter circuit arranged for producing an analog version of the phase signal.

**12.** A circuit as claimed in claim 11, further comprising:

a converter circuit coupled to the first digital-to-analog converter circuit; and
a second envelope detector circuit coupled between the converter circuit and the fourth input terminal.

**13.** A circuit, comprising:

a first amplifier circuit having a first input terminal, a second input terminal and a first output terminal, the first input terminal coupled for receiving an amplitude signal, the second input terminal coupled for receiving a phase signal; and
a processor circuit having a second output terminal coupled to the first input terminal, having a third output terminal coupled to the second input terminal, and having a third input terminal coupled to the first output terminal.

**14.** A circuit as claimed in claim 13, wherein the first input terminal comprises a power supply terminal.

**15.** A circuit as claimed in claim 13 or claim 14, wherein the first amplifier comprises a power amplifier arranged for producing an amplitude and phase modulated signal at the first output terminal.

**16.** A circuit as claimed in any of claims 13 to 15, further comprising:

an analog-to-digital converter coupled between the first output terminal and the third input terminal;
a first digital-to-analog converter coupled between the second output terminal and the first input terminal; and
a second digital-to-analog converter coupled between the third output terminal and the second input terminal.

**17.** A circuit as claimed in claim 16, further comprising:

a transmit loop circuit having a loop input terminal coupled between the second digital-to-analog converter and the second input terminal.

**18.** A circuit as claimed in claim 17, further comprising:

a mixer circuit coupled between the analog-to-digital converter and the first output terminal; and
a filter circuit coupled between the analog-to-digital converter and the mixer circuit.

**19.** A method of producing an amplitude and phase modulated signal comprising the steps of:

applying an amplitude signal to a first input terminal of a power amplifier circuit;
applying a phase signal to a second input terminal of the power amplifier circuit;
producing the amplitude and phase modulated signal at an output terminal of the power amplifier circuit.

**20.** A method as claimed in claim 19, further comprising: applying the amplitude and phase modulated signal to a transmit antenna.

**21.** A method as claimed in claim 19 or claim 20, further comprising:

producing an amplitude reference signal;
producing an amplitude sample signal from the amplitude and phase modulated signal;
comparing the amplitude reference signal to the amplitude sample signal; and
producing the amplitude signal in response to the step of comparing.

## FIG. 1 (PRIOR ART)

Phase information — *100* — TX-Loop — *102* — *104* — PA — *106* — *108* — RF

## FIG. 2 (PRIOR ART)

$f_{REF}$ — *200* — ÷R — *202* — counters — ÷N — *204* — PD — *206* — phase detector — charge pump — *208* — loop filter — *210* — VCO — *212* — *104* — RF

modulator — *226* — 90° — *222* — *218* — I — *216* — down mixer — *214* — ×

+ — *228* — × — *224* — *220* — Q

bus — *230* — on-chip circuitry — $f_{LO}$

source
signal

digital
predistorter ~302

DAC ~304

quadrature
modulator ~306

nonlinear
amplifier

~310

300

308

312

look-up
table ~320

adaptation

ADC

quadrature
demodulator

318

316

314

FIG. 3

(PRIOR ART)

Envelope Detector

Amplitude information

_416_

_414_

_418_

Amplifier

_420_

_412_

Supply

Phase Information

_402_

_422_

Attenuator

_410_

RF

_400_

TX-Loop

_404_

PA

_406_

_408_

FIG. 4

ED1

_418_

_414_

ED2

BPF

_518_

_516_

_416_

_530_

_420_

LO

_514_

_512_

Supply

IF IN

_502_

_402_

_422_

_508_

Directional
Coupler

_510_

RF

Limiter

TX-Loop

_404_

_406_

_408_

_500_

FIG. 5

FIG. 6

FIG. 7